# DEMANDE DE BREVET EUROPEEN

(11) **EP 2 077 565 A1**
(43) Date de publication de la demande: **08.07.2009**
(21) Numéro de dépôt: 08172908.9
(22) Date de dépôt: 24.12.2008
(51) Int. Cl.: H01B 7/295, H01B 13/14, H01B 13/06, H01B 3/46, H01B 3/44, G03F 7/075, C08L 23/12, C08L 83/04, C08L 83/06, C08J 3/24, C08J 3/28, C08K 5/07, G02B 6/44

(54) **Composition photoréticulable comprenant un polyorganosiloxane**

(30) Priorité: 04.01.2008 FR 0850044
(71) Demandeur: Nexans, 75008 Paris (FR)
(72) Inventeur: Pinto, Olivier, 69003, LYON (FR); Alric, Jérôme, 38080, L'ISLE D'ABEAU (FR); Thivillon, Maud, 69510, THURINS (FR)
(74) Mandataire: Peguet, Wilfried

(57) **Abrégé**

La présente invention concerne une composition photoréticulable comprenant un polyorganosiloxane P ayant une viscosité d'au moins 10 000 mPa.s à 25°C, caractérisée en ce qu'elle comprend en outre une huile silicone acrylée en tant qu'agent de réticulation, et un photoamorceur dont la structure chimique comporte un groupement diaryl cétone.

## Description

La présente invention se rapporte à une composition photoréticulable, à un câble électrique et/ou optique comprenant au moins une couche réticulée obtenue à partir d'une composition photoréticulable, ainsi qu'à un procédé de fabrication dudit câble.

Elle s'applique typiquement, mais non exclusivement, à la fabrication de couches d'isolation diélectrique ou de couches de protection (gaine de protection) pour câbles électriques et/ou optiques.

Dans un exemple de réalisation, cette composition est utilisée pour isoler les câbles électriques dits céramisables ou de sécurité.

Les gommes silicones réticulées sont utilisées typiquement en tant que couche d'isolation diélectrique pour câbles électriques et présentent en outre de bonnes propriétés de stabilité thermique dans une large gamme de température pouvant aller de -50°C à 200°C.

Il est bien connu que les procédés de réticulation (vulcanisation) des gommes silicones sont classiquement amorcés par la réaction de décomposition thermique de peroxydes.

Plus particulièrement, on mélange un polyorganosiloxane avec un peroxyde au sein même d'une extrudeuse, et la réticulation s'effectue en sortie d'extrudeuse sous l'action de la chaleur soit en faisant passer le mélange extrudé à l'intérieur d'un tube de vulcanisation, soit en immergeant ledit mélange dans un bain de sel.

Toutefois, ces deux procédés de réticulation à chaud nécessitent des coûts d'installation et de maintenance élevés.

De plus, lorsque les peroxydes utilisés ont une température de décomposition relativement basse, comme par exemple le peroxyde de 4,4'-dichlorobenzoyle qui se décompose à partir de 40°C, le débit de l'extrudeuse doit être limité de façon significative en raison de l'échauffement du mélange dû aux contraintes de cisaillement à l'intérieur de l'extrudeuse, et de ce fait, la vitesse de la ligne de fabrication doit également être limitée.

En effet, cet échauffement (auto-échauffement) peut entraîner la réticulation prématurée du polyorganosiloxane dans l'outillage d'extrusion et ainsi endommager ledit outillage.

La réticulation prématurée du polyorganosiloxane induit ainsi une dégradation de la qualité de la couche d'isolation obtenue, notamment de ses propriétés mécaniques et diélectriques.

Dans des domaines techniques complètement différents du domaine de la câblerie, on connaît des compositions photoréticulables comprenant un polyorganosiloxane, une huile silcone acrylée et un photoamorceur de type Norrish I.

Le but de la présente invention est de pallier les inconvénients des techniques de l'art antérieur en offrant notamment une composition photoréticulable destinée à être utilisée en câblerie et à réticuler à vitesse relativement élevée tout en présentant de bonnes propriétés mécaniques et diélectriques une fois ladite composition réticulée.

La présente invention a pour premier objet une composition photoréticulable comprenant un polyorganosiloxane P ayant une viscosité d'au moins 10 000 mPa.s à 25°C, caractérisée en ce qu'elle comprend en outre :
- une huile silicone acrylée en tant qu'agent de réticulation, et
- un photoamorceur dont la structure chimique comporte un groupement diaryl cétone.

Selon un mode particulier de ce premier objet, la composition photoréticulable peut comprendre au plus 40 parties en poids de ladite huile silicone acrylée pour 100 parties en poids de polyorganosiloxane P.

La présente invention a pour second objet une composition photoréticulable comprenant un polyorganosiloxane P ayant une viscosité d'au moins 10 000 mPa.s à 25°C, caractérisée en ce qu'elle comprend en outre :
- au plus 40 parties en poids d'une huile silicone acrylée en tant qu'agent de réticulation pour 100 parties en poids de polyorganosiloxane P, et
- un photoamorceur apte à arracher un atome d'hydrogène au polyorganosiloxane P lorsque ledit photoamorceur est soumis à un rayonnement actinique.
   L'homme du métier pourra facilement identifier ce type de photoamorceur du fait de l'obtention de la réticulation du polyorganosiloxane P après irradiation de la composition photoréticulable sous un rayonnement actinique, ladite réticulation étant telle que déterminée par les méthodes décrites dans les exemples mentionnés ci-après.
   Selon un mode particulier de ce second objet, la structure chimique dudit photoamorceur peut comporter un groupement diaryl cétone.
   La voie photochimique de réticulation de la composition photoréticulable selon la présente invention permet avantageusement de fabriquer une couche réticulée avec une productivité élevée, et, plus particulièrement dans le domaine de la câblerie, elle permet de s'affranchir des problèmes de réticulation prématurée lors notamment de l'extrusion de ladite composition.
   En outre, les conditions de stockage de ladite composition photoréticulable sont nettement facilitées, car la composition photoréticulable est insensible à des variations de température de forte amplitude allant de
- 20°C jusqu'à +50°C et une réticulation prématurée ne peut ainsi avoir lieu.

Dans le texte de la présente invention, l'expression « compris(e) entre une valeur v1 et une valeur v2 » signifie que les valeurs v1 et v2 sont incluses dans cet intervalle de valeurs.

Les polyorganosiloxanes P selon la présente invention comprennent autant les polyorganosiloxanes de viscosité comprise entre 10 000 mPa.s et 1 000 000 mPa.s à 25°C, à savoir les gommes silicones dites liquides (LSR pour l'anglicisme Liquid Silicone Rubber) que les polyorganosiloxanes de viscosité supérieure à 1 000 000 mPa.s à 25°C communément appelés gommes silicones à ultra haute viscosité, ou un de leurs mélanges.

La viscosité des LSR est de préférence comprise entre 10 000 et 100 000 mPa.s, tandis que la viscosité des gommes silicones à ultra haute viscosité est de préférence comprise entre 10 000 000 et 50 000 000 mPa.s.

La viscosité des gommes silicones étant constante dans une large plage de température, toutes les viscosités mentionnées dans la présente invention sont données à 25°C.

La viscosité des LSR est classiquement mesurée, dans la présente invention, par rhéométrie de type Couette à 25°C, cette méthode convient aux mesures de viscosité allant de 10 000 mPa.s à 100 000 mPa.s. Pour des mesures de viscosité allant de 100 000 mPa.s à 1 000 000 mPa.s, la viscosité des LSR dans la présente invention est classiquement mesurée par rhéométrie de type plan-plan ou de type cone-plan à 25°C.

La viscosité des gommes silicones à ultra haute viscosité est classiquement mesurée, dans la présente invention, par rhéométrie dynamique ou rhéométrie capillaire à 25°C, avec un cisaillement d'environ 1 s⁻¹.

Lesdits polyorganosiloxanes P sont généralement représentés par la formule I suivante : 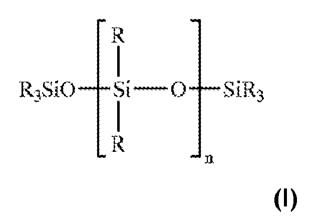 dans laquelle n est un nombre entier qui est fonction de la viscosité du polyorganosiloxane, de préférence n est supérieur à 500 ; les groupements R comprennent des radicaux hydrocarbonés, identiques ou différents, choisis parmi des groupements alkyles, notamment en C₁₋₂₀, halogénoalkyles, cycloalkyles, aralkyles, et/ou cyanoalkyles.

A titre d'exemple préféré, le groupement R représente un groupement méthyle.

Avantageusement, les groupements R peuvent comprendre au moins 50% d'un des groupements mentionnés précédemment.

Les groupements R peuvent comprendre en outre d'autres radicaux hydrocarbonés, identiques ou différents, choisis parmi des groupements alkényles, halogénoalkényles, cylcloalkényles aryles, halogénoaryles et/ou alkaryles.

Le polyorganosiloxane P préféré selon la formule I est le polydiméthylsiloxane (PDMS).

Les huiles silicones acrylées selon la présente invention comprennent au moins un groupement acrylate ou méthacrylate et ont de préférence une viscosité comprise entre 100 et 1 000 mPa.s à 25°C, de préférence entre 250 et 450 mPa.s à 25°C. La viscosité des huiles silcones acrylées est classiquement mesurée, dans la présente invention, par rhéométrie de type Couette à 25°C.

Ces huiles silicones acrylées peuvent être définies par l'une ou l'autre des formules IIa ou IIb suivantes : 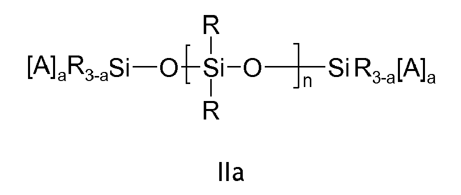 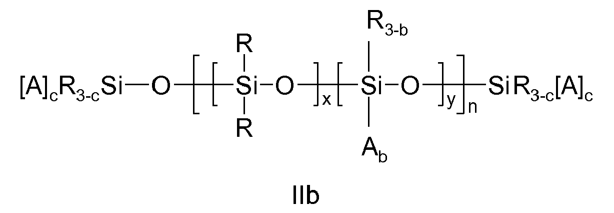 dans laquelle n est un nombre entier inférieur ou égal à 1000 ; x est un nombre compris entre 0,80 et 0,99 ; y est un nombre compris entre 0,01 et 0,20 ; les groupements R sont des radicaux hydrocarbonés, identiques ou différents, choisis préférentiellement parmi des groupements alkyles en C₁₋₂₀, halogénoalkyles, cycloalkyles, aralkyles, cyanoalkyles, alkényles, halogénoalkényles, cylcoalkényles, aryles, halogénoaryles et/ou alkaryles ; a est un nombre entier égal à 1, 2 ou 3 ; b est un nombre entier égal à 1 ou 2 ; c est un nombre entier égal à 0, 1, 2 ou 3 ; A est un groupement comprenant un acrylate ou un méthacrylate, le groupement A pouvant comprendre en outre un groupement de liaison divalent entre le silicium et l'acrylate ou le méthacrylate.

A titre d'exemple, l'huile silicone acrylée est avantageusement le polydiméthylsiloxane acrylé dont la formule IIa ou IIb est définie par a =1, b=1, c=1, et A = acrylate.

Le photoamorceur de la composition selon la présente invention est un photoamorceur de type Norrish II. On entend par « photoamorceur de type Norrish II » un composé chimique qui, lorsqu'il est soumis à un rayonnement actinique, notamment à un rayonnement ultra-violet (UV), passe à un état excité dit état triplet. Cet état triplet permet ainsi au composé chimique d'arracher un atome d'hydrogène au polyorganosiloxane P selon la présente invention, ce qui conduit à la formation d'un macro-radical de polyorganosiloxane P apte à réticuler avec l'agent de réticulation.

Ainsi, les photoamorceurs de type Norrish II sont bien différents des photoamorceurs de type Norrish I. Même si ces deux types de photoamorceurs ont la faculté de générer des radicaux libres subséquemment à l'absorption d'un rayonnement actinique tel qu'un rayonnement ultraviolet, le photoamorceur de type Norrish I est connu pour être apte à initier la formation de radicaux sous rayonnement ultraviolet par scission homolytique de ses liaisons intramoléculaires, ces radicaux n'étant pas apte à arracher un atome d'hydrogène sur le polyoganosiloxane P.

A titre d'exemple, le photoamorceur selon la présente invention, dont la structure chimique comporte notamment un groupement diaryl cétone, peut être choisi parmi la benzophénone, la dibenzosubérone, la xanthone, l'anthrone, l'anthraquinone et leurs dérivés, ou un de leurs mélanges.

Dans un mode de réalisation particulier, la composition selon l'invention peut comprendre au plus 20 parties en poids d'huile silicone acrylée pour 100 parties en poids de polyorganosiloxane P, de préférence au plus 10 parties en poids d'huile silicone acrylée pour 100 parties en poids de polyorganosiloxane P, et encore plus préférentiellement au plus 5 parties en poids d'huile silicone acrylée pour 100 parties en poids de polyorganosiloxane P.

Dans un autre mode de réalisation particulier, la composition selon l'invention peut comprendre au plus 10 parties en poids de photoamorceur pour 100 parties en poids de polyorganosiloxane P, de préférence au plus 5 parties en poids de photoamorceur pour 100 parties en poids de polyorganosiloxane P, et encore plus préférentiellement au plus 2 parties en poids de photoamorceur pour 100 parties en poids de polyorganosiloxane P.

Dans un autre mode de réalisation, la composition peut comprendre en outre un autre amorceur, ce dernier étant différent du photoamorceur apte à arracher un atome d'hydrogène au polyorganosiloxane P lorsque ledit photoamorceur est soumis à un rayonnement actinique.

L'autre amorceur est apte à générer des radicaux libres sous l'effet de la chaleur ou d'un rayonnement actinique.

Ledit amorceur apte à générer des radicaux libres sous l'effet de la chaleur peut être un peroxyde organique, comme par exemple le peroxyde de 4,4'-dichlorobenzoyle. La composition peut comprendre de préférence au plus 0,3 partie en poids de peroxyde organique pour 100 parties en poids de polyorganosiloxane P.

Ledit amorceur apte à générer des radicaux libres sous l'effet d'un rayonnement actinique peut être un photoamorceur de type Norrish I, comme par exemple la 2,4,6-trimethyl benzoyl phosphine oxide (MAPO) ou la diphenyl (2,4,6-trimethylbenzoyl)-phosphine oxide (BAPO).

Un autre objet selon la présente invention est un câble électrique et/ou optique comprenant au moins une couche réticulée obtenue à partir d'une composition photoréticulable conforme à l'invention, ou en d'autres termes une couche réticulée de polyorganosiloxane P.

Ledit câble peut comprendre en outre une couche de polyoléfine chargée, ladite couche étant réticulée ou non.

La couche de polyoléfine chargée est de préférence du type HFFR (pour l'anglicisme *Halogen Free Flame Retardant*) et comprend une matrice de polyoléfine et une charge dite ignifugeante bien connue de l'homme du métier.

A titre d'exemple, la polyoléfine est un polymère d'éthylène ou de propylène et la charge ignifugeante est un hydroxyde métallique tel qu'un trihydroxyde d'aluminium ou un dihydroxyde de magnésium.

Lorsque l'élément conducteur du câble électrique et/ou optique est entouré de ces deux couches, il est préférable que la couche réticulée de polyorganosiloxane P, autour de l'élément conducteur, soit recouverte par la couche de polyoléfine chargée.

Ainsi, la couche réticulée de polyorganosiloxane P, présentant classiquement une faible résistance à l'abrasion, est protégée par ladite couche de polyoléfine chargée, cette dernière présentant au contraire une très bonne résistance à l'abrasion.

Un autre objet selon la présente invention est un procédé de fabrication dudit câble électrique et/ou optique, ledit procédé comprenant une étape i d'irradiation de la composition photoréticulable sous un rayonnement actinique, de préférence sous ultra violet, pour obtenir la couche réticulée de polyorganosiloxane P.

Ce procédé permet d'obtenir une couche réticulée de polyorganosiloxane P à l'aide d'un procédé facile à mettre en oeuvre, à haute productivité et très économique par rapport aux procédés de l'art antérieur utilisés pour la réticulation par voie thermique.

Les propriétés mécaniques et diélectriques de la couche réticulée de polyorganosiloxane P obtenue par le procédé de fabrication selon la présente invention sont équivalentes, voire meilleures, à celle obtenues par les procédés classiques de réticulation à chaud des gommes silicones utilisées en câblerie.

Avantageusement, l'étape i peut être précédée d'une étape d'extrusion de la composition photoréticulable conforme à la présente invention.

Le procédé de réticulation par voie photochimique selon la présente invention permet d'éviter toute réaction de réticulation prématurée dans l'outillage d'extrusion du fait de l'auto-échauffement de la composition photoréticulable lors du processus d'extrusion.

De plus, la réticulation du polyorganosiloxane P se fait à température ambiante et ne nécessite donc pas un chauffage de la composition photoréticulable, notamment après sa sortie d'extrudeuse.

Il est ainsi tout à fait envisageable de moduler le degré de réticulation du polyorganosiloxane P et donc d'adapter ses propriétés mécaniques en réalisant une ou plusieurs irradiations sous un rayonnement actinique, plus particulièrement un ou plusieurs passages dans un four à rayonnements UV.

De cette façon, la vitesse d'extrusion n'est pas limitée par la cinétique de réticulation de la gomme silicone.

Lorsque le câble électrique et/ou optique selon la présente invention comprend en outre la couche de polyoléfine chargée mentionnée ci-avant, le procédé de fabrication dudit câble comprend ladite étape i suivie d'une étape ii de mise en contact de ladite couche réticulée de polyorganosiloxane P avec ladite couche de polyoléfine chargée, pour obtenir un matériau bicouche.

Ce procédé permet d'obtenir un matériau bicouche de haute valeur ajoutée à l'aide d'un procédé facile à mettre en oeuvre et avec une productivité élevée, ledit matériau bicouche combinant de très bonnes propriétés diélectriques et mécaniques avec un comportement retardateur au feu excellent.

Avantageusement, la mise en contact de la couche de polyoléfine chargée de l'étape ii avec la couche réticulée de polyorganosiloxane P de l'étape i peut être obtenue à partir de l'extrusion d'une polyoléfine chargée directement autour de la couche de l'étape i.

D'autres caractéristiques et avantages de la présente invention apparaîtront à la lumière des exemples qui vont suivre en référence aux figures annotées, lesdits exemples et figures étant donnés à titre illustratif et nullement limitatif.

La figure 1 représente de manière schématique un procédé de fabrication d'un câble comprenant au moins une couche réticulée conforme à la présente invention.

La figure 2 représente de manière schématique un procédé de fabrication d'un câble comprenant une couche réticulée et une autre couche comprenant une polyoléfine chargée conforme à la présente invention.

### Exemples

Afin de montrer les avantages obtenus avec les compositions photoréticulables selon la présente invention, le degré de réticulation, le fluage à chaud ainsi que certaines propriétés mécaniques des couches réticulées selon l'invention et l'art antérieur ont été étudiées

Le degré de réticulation (ou taux de gel) d'une couche réticulée est typiquement déterminé par extraction d'un échantillon de ladite couche dans le xylène à 110°C pendant 24 heures.

La mesure du fluage à chaud d'un matériau sous contrainte mécanique, quant à elle, est déterminée selon la norme NF EN 60811-2-1.

Ce test correspondant est communément désigné par l'anglicisme Hot Set Test et consiste à lester une extrémité d'une éprouvette de type haltère H2 avec une masse correspondant à l'application d'une contrainte équivalente à 0,2MPa, et à placer l'ensemble dans une étuve chauffée à 200+/-1 °C pendant une durée de 15 minutes.

Au terme de ce délai, on relève l'allongement maximale à chaud sous contrainte de l'éprouvette, exprimé en %.

La masse suspendue est alors retirée, et l'éprouvette est maintenue dans l'étuve pendant 5 nouvelles minutes.

L'allongement permanent restant, également appelé rémanence (ou élongation rémanente), est alors mesuré avant d'être exprimé en %.

On rappelle que plus un matériau est réticulé, plus les valeurs d'allongement maximal sous contrainte et de rémanence seront faibles.

On précise par ailleurs que dans le cas où une éprouvette viendrait à se rompre en cours d'essai, sous l'action conjuguée de la contrainte mécanique et de la température, le résultat au test serait alors logiquement considéré comme un échec.

Les propriétés mécaniques d'une couche réticulée, en particulier la contrainte à la rupture et l'allongement à la rupture, sont déterminées en découpant des éprouvettes de type haltère H2 selon la norme NF EN 60811-1-1.

Les éprouvettes ainsi préparées et dont l'épaisseur est mesurée avec précision, sont ensuite testées sur un banc de traction mécanique. La vitesse de traction est de 200 mm/mn.

### 1. Première série de test sur une couche réticulée mise en oeuvre sous presse

Une première série de test consiste à étudier notamment les propriétés mécaniques d'une couche réticulée (ou film réticulé) selon la présente invention et selon l'art antérieur.

Les compositions décrites dans cette première série de test ont été préparées en mélangeant leurs constituants respectifs sur un mélangeur à cylindre à température ambiante.

Avant l'incorporation de l'agent de réticulation (huile silicone acrylée) dans la matrice de polyorganosiloxane P, celui-ci peut-être préalablement adsorbé sur silice (AEROSIL R202 DEGUSSA) afin de faciliter sa dispersion dans la matrice polyorganosiloxane.

En outre, afin d'éviter l'exsudation du photoamorceur après l'étape de mélange, un solvant organique de bas point d'ébullition, tel que l'acétate d'éthyle, peut être utilisé.

### 1.a. Couches réticulées à base de silicone liquide

On étudie les propriétés mécaniques de couches réticulées à base d'un élastomère de silicone liquide (LSR) (polyorganosiloxane P).

100 parties en poids de la partie A d'un LSR de viscosité comprise entre 10 000 mPa.s et 100 000 mPa.s composé d'un mélange d'huile silicone hydrogéné et d'huile silicone vinylée (référencé LSR8540-A et commercialisée par la société BLUESTAR SILICONE) sont mélangées avec 5 parties en poids d'huile silicone acrylée de viscosité comprise entre 250 et 450 mPa.s (référencée TEGORAD 2700 et commercialisée par la société TEGO) et avec 2 parties en poids de benzophénone (référencé Darocur BP et commercialisé par la société CIBA).

La composition ainsi mélangée est mise en forme sous presse à température ambiante (25°C) pour obtenir une couche de 550 µm d'épaisseur.

La plaque ainsi obtenue est photoréticulée par passages successifs sur un convoyeur UV (LC6 UV FUSION) équipé d'un four UV (HP6 FUSION UV - 200W/cm) et d'une lampe moyenne pression à vapeur de mercure de type D (Irradiance 6700 W/cm2).

Après 10 passages successifs à la vitesse de 2,5 m/mn dans ledit four UV, on obtient une couche réticulée selon la présente invention.

Parallèlement, 100 parties en poids des parties A et B de l'élastomère silicone (LSR) sont réticulées thermiquement pendant une heure à 120°C, la partie B de l'élastomère silicone comprenant typiquement un mélange d'huile silicone vinylée et un catalyseur d'hydrosilylation.

La couche obtenue par la voie photochimique selon l'invention présente un allongement à la rupture comparable à celui de la couche obtenue par la voie thermique en présence d'un catalyseur, à savoir 350%.

### 1.b. Couches réticulées à base d'un élastomère vulcanisable à chaud

On étudie le taux de gel, le fluage à chaud ainsi que les propriétés mécaniques de couches réticulées à base d'un élastomère vulcanisable à chaud (EVC) (polyorganosiloxane P).

Des couches de 800 µm d'épaisseur sont réalisées avec un élastomère vulcanisable à chaud de viscosité comprise entre 10 000 000 mPa.s et 50 000 000 mPa.s, utilisé comme base dans l'isolation de câble de sécurité.

Le Tableau 1 suivant détaille les différentes compositions utilisées pour former des couches réticulées selon l'art antérieur (compositions A1 et A2) et selon la présente invention (compositions B et C).

A cet égard, il est noté que les quantités mentionnées dans le Tableau 1 sont exprimées en parties en poids pour 100 parties en poids de polyorganosiloxane P.

**Tableau 1**

| Composition | A1 | A2 | B | C |
|---|---|---|---|---|
| ELASTOSIL R502/75 | 100 | 100 | 100 | 100 |
| Peroxide de 4,4'-dichlorobenzoyle | 0,6 | - | - | 0,25 |
| BAPO | - | 0, 5 | - | - |
| Darocur BP | - | - | 0,5 | 0,5 |
| Tegorad 2700 | - | 5 | 5 | 5 |

L'origine des constituants du Tableau 1 est la suivante :
- ELASTOSIL R502/75 est la référence d'un élastomère vulcanisable à chaud de viscosité comprise entre 10 000 000 mPa.s et 50 000 000 mPa.s à 25°C, commercialisé par la société WACKER SILICONES ;
- le peroxyde de 4,4'-dichlorobenzoyle est fourni par la société WACKER SILICONES ;
- le BAPO est le 2,4,6-trimethyl benzoyl phosphine oxide, référencé Irgacure 819 et commercialisé par la société Ciba ;
- Darocur BP est la référence d'une benzophénone commercialisée par la société CIBA ; et
- Tegorad 2700 est la référence d'une huile silicone acrylée commercilaisée par la société TEGO.

La composition A1 est mise en oeuvre sous presse à 200°C pendant 10 secondes (réticulation par voie thermique).

Les compositions A2, B et C sont, quant à elles, mises en oeuvre sous presse à température ambiante (25°C) et photoréticulées dans les mêmes conditions que la couche réticulée à base de LSR décrite précédemment (10 passages successifs à 5m/mn).

Le taux de gel, le fluage à chaud ainsi que les propriétés mécaniques caractéristiques des couches réticulées obtenues sont présentées dans le Tableau 2 suivant :

**Tableau 2**

| Couche réticulée | A1 | A2 | B | C |
|---|---|---|---|---|
| Taux de Gel (%) (Extraction dans le Xylène à | 96 | <5 | 95 | 96 |
| 110°C pendant 24h) | | | | |
| Fluage à chaud (à 250°C et à 0,2 MPa | | | | |
| pendant 15min) | | | | |
| - allongement maximale à chaud sous | 10 | Echec | 10 | 10 |
| contrainte (%) | | | | |
| - Elongation rémanente (%) | 0 | Echec | 0 | 0 |
| **Propriétés mécaniques (sans vieillissement)** | | | | |
| - Contrainte à la rupture (MPa) | 7,3 | Néant | 5,2 | 5.8 |
| - Allongement à la rupture (%) | 620 | Néant | 540 | 490 |
| **Propriétés mécaniques après vieillissement** | | | | |
| sous air (à 200°C pendant 240h) | | | | |
| - Contrainte rupture (MPa) | 5.0 | Néant | 4 | 4.2 |
| - Elongation rupture (%) | 260 | Néant | 140 | 125 |

Les couches réticulées B et C par voie photochimique présentent des degrés de réticulation et des propriétés mécaniques sensiblement équivalents à ceux obtenus avec la couche réticulée A1 par voie thermique.

Par ailleurs, on remarque que l'utilisation d'un photoamorceur de type Norrish I tel que le BAPO ne permet pas d'obtenir un taux de gel suffisant pour la caractérisation du fluage à chaud et des propriétés mécaniques de la couche « réticulée » A2.

De plus, les caractéristiques du fluage à chaud ainsi que les propriétés mécaniques des couches réticulées B et C répondent à la norme BS7655 relative aux câbles de sécurité comportant une isolation diélectrique élastomèrique.

La norme BS7655 préconise pour le fluage à chaud, un allongement maximal à chaud sous contrainte inférieure à 100% et une élongation rémanente inférieure à 25%.

Elle préconise également une contrainte à la rupture supérieure ou égale à 5 MPa et un allongement à la rupture supérieure ou égale à 150 % pour les couches réticulées « sans vieillissement ».

Lorsque les couches réticulées subissent un vieillissement à 200°C pendant 240 heures sous air, la contrainte à la rupture et l'allongement à la rupture préconisés par la norme BS7655 sont respectivement supérieure ou égale à 4 MPa et supérieure ou égale à 120MPa.

Il est intéressant de remarquer que, en combinant une très faible quantité de peroxyde (0,2 parties en poids) avec un photoamorceur de type Norrish II selon la composition C, les propriétés mécaniques de la couche réticulée C sont améliorées de façon remarquable par rapport à la couche réticulée B.

En effet, la vulcanisation par le peroxyde provient du fait qu'une partie du rayonnement du four UV génère des rayonnements infra rouge qui permettent au peroxyde de se décomposer et de participer à la réticulation du polyorganosiloxane P.

Cette quantité de peroxyde étant relativement faible, notamment moins de la moitié de la quantité de peroxyde de la composition A, les risques de réticulation prématurée dans l'outillage d'extrusion sont limités de façon significative.

### 1.c. Couches réticulées à base de silicone à ultra haute viscosité

On étudie les propriétés mécaniques de couches réticulées à base de silicone à ultra haute viscosité (polyorganosiloxane P).

100 parties en poids de polydiméthylsiloxane (PDMS) à ultra haute viscosité (viscosité comprise entre 10000 000 mPa.s et 50000 000 mPa.s) (référencé GENIOPLAST Pellet S, et commercialisé par WACKER SILICONES) sont mélangées avec 5 parties en poids d'une huile silicone diacrylée (référencé TEGORAD 2700, et commercialisé par DEGUSSA) et avec 0,5 partie en poids d'une benzophénone (référencée DAROCUR BP, et commercialisée par CIBA) (composition D).

Des couches réticulées par voie photochimiques sont préparées à partir dudit mélange (composition D) après 3 passages successifs à la vitesse de 5m/mn sous le convoyeur UV (LC6 UV FUSION) équipé d'un four UV (HP6 FUSION UV - 200W/cm) et d'une lampe moyenne pression à vapeur de mercure de type D (Irradiance 6700 W/cm2).

Les propriétés mécaniques des couches réticulées D1 et D2 obtenues à partir de la composition D sont reportées dans le Tableau 3 suivant.

**Tableau 3**

| Couche réticulée | D1 | D2 |
|---|---|---|
| Epaisseur (mm) | 0,200 | 0,850 |
| **Propriétés mécaniques (sans vieillissement)** | | |
| - Contrainte à la rupture (MPa) | 6,5 | 5,5 |
| - Allongement à la rupture (%) | 680 | 1010 |

On observe ainsi que les propriétés mécaniques des couches réticulées D1 et D2 par voie photochimique sont conservées lorsque l'épaisseur de la couche passe de 0,200 mm à 0,850 mm.

### 2. Seconde série de test sur une couche réticulée d'un câble électrique, mise en forme par extrusion

Une seconde série de test consiste à étudier le taux de gel ainsi que les propriétés mécaniques de la couche réticulée (ou film réticulé) de polyorganosiloxane P d'un câble conforme à la présente invention.

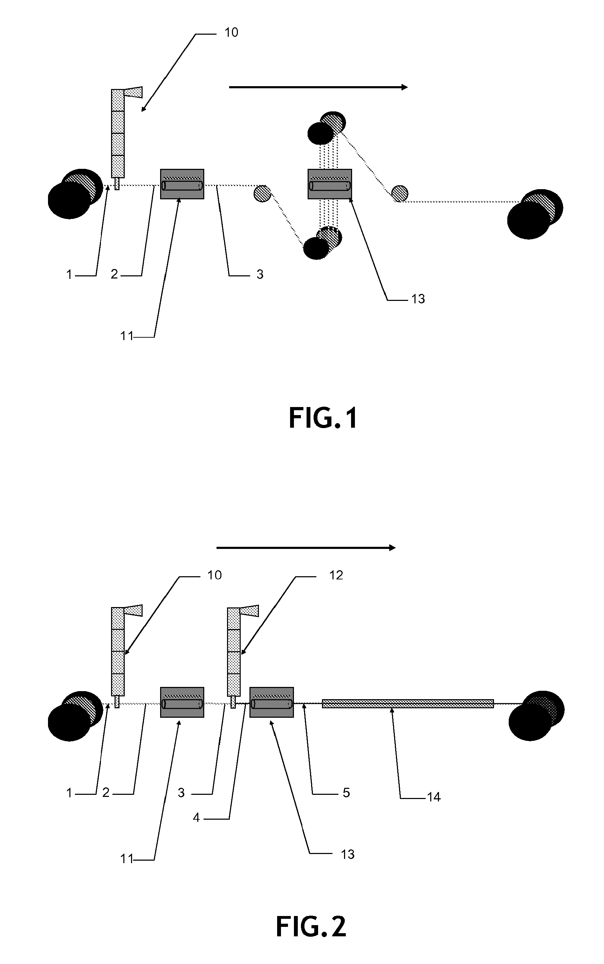

Le procédé de fabrication dudit câble comprenant ladite couche réticulée conforme à la présente invention est représenté de manière schématique sur la figure 1.

La flèche horizontale sur la figure 1 représente le sens de fabrication dudit câble, la vitesse de la ligne de fabrication étant de l'ordre de 20m/min.

La composition photoréticulable utilisée pour l'obtention de la couche réticulée est la composition C du Tableau 1.

La composition C est tout d'abord chargée dans une extrudeuse 10, puis est extrudée directement autour d'un élément conducteur du type fil de cuivre 1 d'un diamètre de 1 mm, la couche isolante 2 formée autour dudit conducteur ayant une épaisseur de 0,900 mm.

Le fil de cuivre 1 entouré de la couche isolante 2 extrudée passe ensuite au travers d'un caisson UV 11 (DRF10 FUSION UV) équipé d'une lampe moyenne pression à vapeur de mercure de type D - 240 W/cm (F600 FUSION UV - Irradiance 7500 W/cm2) pour obtenir une couche réticulée 3.

Le câble électrique ainsi formé est d'une part enroulé sur un touret (non représenté) sans que ladite couche ne se déforme afin d'effectuer une première série de test, et d'autre part, passé ensuite 10 fois consécutivement au travers d'un autre caisson UV 13, selon la figure 1, afin de prolonger la réticulation de la couche réticulée 3 et d'effectuer une seconde série de test.

Bien entendu, un seul caisson UV peut également être utilisé pour effectuer une ou plusieurs irradiations de la couche isolante 2 extrudée.

Le Tableau 4 ci-après rassemble les première et seconde séries de test concernant le taux de gel ainsi que les propriétés mécaniques de la couche réticulée 3 autour du conducteur électrique en cuivre.

**Tableau 4**

| Couche réticulée | | E1 | E2 |
|---|---|---|---|
| Vitesse de la ligne de fabrication | | 8 m/min | 18 m/min |
| Après extrusion et 1 passage dans le four UV 11 | Taux de Gel (%) | 94 | 90 |
| | **Propriétés mécaniques (sans vieillissement)** | | |
| | - Contrainte à la rupture (MPa) | 4,9 | 3,2 |
| | - Allongement à la rupture (%) | 321 | 442 |
| Après extrusion, 1 passage dans le four UV 11 et 10 passages supplémentaires dans le four UV 12 | Taux de Gel (%) | 96 | 95 |
| | **Propriétés mécaniques (sans vieillissement)** | | |
| | - Contrainte à la rupture (MPa) | 4,3 | 3,8 |
| | - Allongement à la rupture (%) | 124 | 178 |

Ainsi, on observe de façon avantageuse que le taux de gel et les propriétés mécaniques sont sensiblement équivalents lorsque la vitesse de la ligne de fabrication passe de 8 mètres par minute à 18 mètres par minute.

### 3. Troisième série de test sur un matériau bicouche d'un câble électrique, mis en forme par extrusion

Une troisième série de test consiste à étudier le fluage à chaud, les propriétés mécaniques, ainsi que les propriétés de résistance au feu et propriétés diélectriques d'un matériau bicouche d'un câble conforme à l'invention, ledit matériau bicouche comprenant une couche réticulée directement en contact avec une couche de polyoléfine chargée.

Le procédé de fabrication dudit câble comprenant le matériau bicouche est représenté de manière schématique sur la figure 2.

La flèche horizontale sur la figure 2 représente le sens de fabrication dudit câble, la vitesse de la ligne de fabrication étant de l'ordre de 20m/min.

La composition utilisée pour l'obtention de la couche réticulée du matériau bicouche est la composition D décrite précédemment.

La composition est tout d'abord chargée dans une première extrudeuse 10, puis est extrudée directement autour d'un élément conducteur du type fil de cuivre 1 d'un diamètre de 0,85 mm, la couche isolante 2 formée autour dudit conducteur ayant une épaisseur de 0,200 mm.

Le fil de cuivre 1 entouré de la couche isolante 2 extrudée passe ensuite au travers d'un caisson UV 11 (DRF10 FUSION UV) équipé d'une lampe moyenne pression à vapeur de mercure de type D - 240 W/cm (F600 FUSION UV - Irradiance 7500 W/cm2) pour obtenir une couche réticulée 3.

Puis, un mélange comprenant une matrice de polypropylène et une charge ignifugeante est extrudé à l'état fondu, grâce à une seconde extrudeuse 12, directement autour de la couche 3 réticulée de polyorganosiloxane P en une épaisseur de 0,200 mm.

La couche 4 de polypropylène chargé ainsi obtenue est ensuite réticulée en passant au travers d'un caisson UV 13 (DRF10 FUSION UV) équipé d'une lampe moyenne pression à vapeur de mercure de type D - 240 W/cm (F600 FUSION UV - Irradiance 7500 W/cm2).

Le câble 5, plus particulièrement la couche réticulée de polyoléfine chargée, est ensuite refroidie dans un bac de refroidissement 14.

La couche 4 de polypropylène chargé en contact direct avec la couche 3 réticulée de polyorganosiloxane P forme ainsi le matériau bicouche.

Afin de montrer les avantages du matériau bicouche conforme à l'invention, le fluage à chaud et les propriétés mécaniques du câble 5 ainsi obtenu, référencé MB1 pour les tests, ont été déterminées selon la norme NF EN 60811.

En outre, les propriétés de résistance au feu ainsi que les propriétés diélectriques ont également été mesurées.

Les propriétés de résistance au feu sont caractérisées conformément à la norme IEC 60332-1 décrivant le test de propagation à la flamme.

Ainsi, l'échantillon d'essai pour ce test est une partie du câble 5, tel qu'obtenu à partir du procédé décrit ci-avant selon la figure 2, d'environ 600 mm de long.

Cet échantillon est aligné verticalement et fixé à deux supports de telle sorte que la distance entre ceux-ci soit d'environ 550 mm.

Le brûleur est placé de façon à avoir un angle de 45° entre la flamme et l'échantillon, le cône bleu de la flamme devant toucher la surface de l'échantillon.

La flamme est appliquée de façon continue pendant une durée de 60 secondes.

A la fin du temps spécifié, le brûleur est écarté et la flamme éteinte.

Les critères de succès du test de propagation à la flamme sont la distance brûlée et le temps d'extinction de la flamme.

Pour que l'échantillon passe le test avec succès, il faut que la distance brûlée ne dépasse pas 375 mm à l'issue de l'essai.

Les propriétés diélectriques du câble sont caractérisées conformément à la norme EN 50305 décrivant le test de stabilité en courant continu.

Ainsi, l'échantillon d'essai pour ce test est une partie du câble 5, tel qu'obtenu à partir du procédé décrit ci-avant selon la figure 2, d'au moins 5 m de long disposé en couronne.

Ladite couronne est immergée dans une solution d'eau distillée contenant 3% de chlorure de sodium, à une température de 85°C et pendant 240h sous une tension de 300V en courant continu.

Pour ce faire, une électrode est reliée aux deux extrémités non immergées du câble, pendant que la deuxième électrode est plongée dans la solution contenant le câble immergé.

Le courant circulant dans le circuit (courant de fuite) est mesuré en continu tout au long du test.

A l'issue de l'essai, on ne doit pas observer de claquage de l'enveloppe isolante.

Afin de comparer facilement les avantages du matériau bicouche selon la présente invention, le test de la propagation de la flamme et le test de stabilité en courant continu ont également été réalisés :
- sur un câble référencé C1 obtenu à partir du procédé décrit précédemment selon la figure 1 comprenant une unique couche photoréticulée obtenue à partir de la composition D (épaisseur de 0,200 mm) conforme à l'invention, et
- sur un câble référencé C2 obtenu à partir du procédé selon la figure 2, mais ne comprenant uniquement que l'étape relatif à la couche de polypropylène chargée réticulée (épaisseur de 0,350 mm), ou en d'autres termes le câble C2 comprend un élément conducteur entouré par une unique couche réticulée de polypropylène chargée.

**Tableau 5**

| Câble | MB1 | C1 | C2 |
|---|---|---|---|
| **Fluage à chaud** (à 250°C et à 0,2 MPa pendant 15min) | | | |
| - allongement maximale à chaud sous contrainte (%) | 30 | / | / |
| - Elongation rémanente (%) | 0 | | |
| **Propriétés mécaniques (sans vieillissement)** | | | |
| - Contrainte rupture (MPa) | 12 | / | / |
| - Elongation rupture (%) | 200 | | |
| **Propagation de la flamme** | | | |
| - Distance moyenne brulée (mm) | 135 | 118 | 130 |
| - Temps moyen d'extinction (s) | 6 | 0 | 9 |
| **Stabilité diélectrique** | | | |
| - Tenue avant claquage (h) | 180 | / | 2,5 |

Tout en présentant de bonnes propriétés de résistance au feu, le câble MB1 isolé avec le matériau bicouche, tient en moyenne 180 heures, avant d'observer un claquage de l'isolant (sur 5 échantillons testés) contrairement au câble C2 isolé avec une unique couche de polyoléfine chargée qui ne tient que 2h30.

Par conséquent, la couche réticulée de polyorganosiloxane P, entourée par la couche de polyoléfine chargée, permet d'obtenir un matériau bicouche aux propriétés diélectriques améliorées de façon significative comme le montre les résultats obtenus entre le câble MB1 conforme à l'invention et le câble C2.

La présente invention n'est pas limitée aux exemples de compositions et de mises en oeuvre qui viennent d'être décrits et porte dans sa généralité sur toutes les compositions photoréticulables envisageables à partir des indications générales fournies dans l'exposé de l'invention.

Notamment, les compositions photoréticulables selon la présente invention peuvent également être utilisées dans d'autres domaines d'application que celui de la câblerie, comme par exemple pour des applications relatives aux revêtements dans le domaine du textile ou dans le domaine du papier.

## Revendications

1. Composition photoréticulable comprenant un polyorganosiloxane P ayant une viscosité d'au moins 10 000 mPa.s à 25°C, **caractérisée en ce qu'**elle comprend en outre :
- une huile silicone acrylée en tant qu'agent de réticulation, et
- un photoamorceur dont la structure chimique comporte un groupement diaryl cétone.

2. Composition selon la revendication 1, **caractérisée en ce qu'**elle comprend au plus 40 parties en poids de ladite huile silicone acrylée pour 100 parties en poids de polyorganosiloxane P.

3. Composition photoréticulable comprenant un polyorganosiloxane P ayant une viscosité d'au moins 10 000 mPa.s à 25°C, **caractérisée en ce qu'**elle comprend en outre :
- au plus 40 parties en poids d'une huile silicone acrylée en tant qu'agent de réticulation pour 100 parties en poids de polyorganosiloxane P, et
- un photoamorceur apte à arracher un atome d'hydrogène au polyorganosiloxane P lorsque ledit photoamorceur est soumis à un rayonnement actinique.

4. Composition selon la revendication 3, **caractérisée en ce que** la structure chimique dudit photoamorceur comporte un groupement diaryl cétone.

5. Composition selon l'une quelconque des revendications précédentes, **caractérisée en ce que** le photoamorceur est choisi parmi la benzophénone, la dibenzosubérone, la xanthone, l'anthrone, l'anthraquinone et leurs dérivés, ou un de leurs mélanges.

6. Composition selon l'une quelconque des revendications précédentes, **caractérisée en ce** le polyorganosiloxane est choisi parmi les polyorganosiloxanes d'une viscosité comprise entre 10 000 mPa.s et 100 000 mPa.s à 25°C, et les polyorganosiloxanes d'une viscosité comprise entre 10 000 000 mPa.s et 50 000 000 mPa.s à 25°C, ou un de leurs mélanges.

7. Composition selon l'une quelconque des revendications précédentes, **caractérisée en ce que** le polyorganosiloxane P est un polydiméthylsiloxane (PDMS).

8. Composition selon l'une quelconque des revendications précédentes, **caractérisée en ce que** l'huile silicone acrylée a une viscosité comprise entre 100 et 1 000 mPa.s à 25°C.

9. Composition selon l'une quelconque des revendications précédentes, **caractérisée en ce qu'**elle comprend au plus 20 parties en poids d'huile silicone acrylée pour 100 parties en poids de polyorganosiloxane P.

10. Composition selon l'une quelconque des revendications précédentes, **caractérisée en ce qu'**elle comprend au plus 10 parties en poids de photoamorceur pour 100 parties en poids de polyorganosiloxane P.

11. Composition selon l'une quelconque des revendications précédentes, **caractérisée en ce qu'**elle comprend en outre un autre amorceur apte à générer des radicaux libres sous l'effet de la chaleur ou d'un rayonnement actinique.

12. Composition selon la revendication 11, **caractérisée en ce que** l'amorceur apte à générer des radicaux libres sous l'effet de la chaleur est un peroxyde organique.

13. Composition selon la revendication 12, **caractérisée en ce qu'**elle comprend au plus 0,3 partie en poids de peroxyde organique pour 100 parties en poids de polyorganosiloxane P.

14. Composition selon la revendication 11, **caractérisée en ce que** l'amorceur apte à générer des radicaux libres sous l'effet d'un rayonnement actinique est un photoamorceur de type Norrish I.

15. Câble électrique et/ou optique comprenant au moins une couche réticulée, **caractérisé en ce que** ladite couche est obtenue à partir d'une composition photoréticulable telle que définie aux revendications 1 à 14.

16. Câble selon la revendication 15, **caractérisé en ce qu'**il comprend en outre une couche de polyoléfine chargée.

17. Procédé de fabrication d'un câble électrique et/ou optique selon la revendication 15 ou 16, ledit procédé comprenant une étape i d'irradiation de la composition photoréticulable sous un rayonnement actinique pour obtenir la couche réticulée.

18. Procédé de fabrication selon la revendication 17, **caractérisé en ce que**, lorsque le câble électrique et/ou optique comprend en outre la couche de polyoléfine chargée, l'étape i est suivie d'une étape ii de mise en contact de ladite couche réticulée avec la couche de polyoléfine chargée.

19. Procédé de fabrication selon la revendication 17 ou 18, **caractérisée en ce que** l'étape i est précédée d'une étape d'extrusion de la composition photoréticulable.
